# EUROPÄISCHE PATENTSCHRIFT

(11) **EP 2 609 796 B1**
(45) Veröffentlichungstag und Bekanntmachung des Hinweises auf die Patenterteilung: **08.11.2017**
(21) Anmeldenummer: 11802260.7
(22) Anmeldetag: 17.08.2011
(51) Int. Cl.: H05K 1/16, H05K 1/02, H05K 3/46

(54) **MEHREBENENLEITERPLATTE FÜR HOCHFREQUENZ-ANWENDUNGEN**
MULTI-LEVEL CIRCUIT BOARD FOR HIGH-FREQUENCY APPLICATIONS
CARTE DE CIRCUITS IMPRIMÉS MULTINIVEAU POUR APPLICATIONS HAUTE FRÉQUENCE

(30) Priorität: 26.08.2010 DE 102010035453
(43) Veröffentlichungstag der Anmeldung: 03.07.2013
(73) Patentinhaber: Conti Temic Microelectronic GmbH, 90411 Nürnberg (DE)
(72) Erfinder: MÖLLER, Ulrich, 83607 Holzkirchen (DE); SCHÄFER, Maik, 88048 Friedrichshafen-Kluftern (DE)
(86) Internationale Anmeldenummer: PCT/DE2011/001625
(87) Internationale Veröffentlichungsnummer: WO 2012/025100

(56) Entgegenhaltungen:
- WO-A1-2008/018875
- DE-A1- 10 347 284
- US-A- 6 104 258
- US-A1- 2006 279 940
- US-B1- 7 183 651

## Beschreibung

Die Erfindung betrifft Mehrebenenleiterplatte gemäß dem Oberbegriff von Anspruch 1. Üblicherweise werden gedruckten Schaltungen diskrete Kondensatoren zur Abblockung und Filterung von Spannungen eingesetzt. Diese diskreten Bauteile weisen Anschlussleitungen mit einem induktiven Belag auf, welche im Bereich von Hochfrequenz-Anwendungen zu einem kritischen Resonanz-Verhalten führen können. Zudem ergibt sich bei diesen Frequenzen ein hoher Platzbedarf dieser Bauteile an der Oberfläche des teueren Trägersubstrats aus hochfrequenzgeeignetem Material. Die diskreten Bauteile müssen zusätzlich bestückt werden und die Schaltung muss gegen EMV-Störungen dieser Bauelemente geschützt werden.

Die US 6,104,258 offenbart eine Lösung mit einer Mehrebenenleiterplatte, umfassend vier elektrisch leitfähige Ebenen: eine Signalebene, eine Masselage, eine Spannungslage und eine zweite Signalebene. Die elektrisch leitfähigen Ebenen sind jeweils durch dielektrische Schichten voneinander getrennt. Zwischen der Masselage und der Spannungslage ist dabei eine zusätzliche planare Widerstandsbeschichtung ausgebildet. Weiterhin ist ein Teil der dielektrischen Schicht zwischen der Masselage und der Spannungslage mit einer höheren Dielektrizitätskonstante ausgebildet, als der restliche Teil der dielektrischen Schicht. Zwischen der Masselage und der Spannungslage werden somit sowohl eine elektrische Kapazität als auch ein elektrischer Widerstand geschaffen, wobei die Größe des Teils der dielektrischen Schicht zwischen Masse- und Spannungslage mit der höheren Dielektrizitätskonstante, die Größe der elektrischen Kapazität bestimmt.

Im Stand der Technik sind bereits weitere Mehrebenenleiterplatten für Hochfrequenz Anwendungen bekannt. So eine Mehrebenenleiterplatte besteht dabei natürlich aus zumindest einem ersten Trägersubstrat aus hochfrequenzgeeignetem ersten Material, auf welchem zumindest Teile der Hochfrequenz-Schaltung realisiert sind. Zusätzlich ist jedoch zur Kosteneinsparung für die Spannungsversorgung und andere niederfrequente Schaltungsteile die Verwendung zumindest eines zweites Trägersubstrats aus einem zweiten, billigeren Material bekannt, welches jedoch gegenüber dem 1. Material mit demgegenüber höheren dielektrischen Verlusten verbunden ist. An sich sind derartige Mehrebenenleiterplatten aus unterschiedlichen Trägersubstrat bereits am Markt verfügbar.

Die Aufgabe der vorliegenden Erfindung ist es daher, eine geeignete Mehrebenenleiterplatte für Hochfrequenz-Anwendungen anzugeben. Diese Aufgabe wird durch die Merkmale der unabhängigen Ansprüche gelöst. Vorteilhafte Weiterbildungen der Erfindung ergeben sind aus den Unteransprüchen, wobei auch Kombinationen und Weiterbildungen einzelner Merkmale miteinander denkbar sind.

Ein wesentlicher Gedanke der Erfindung besteht darin, dass die an sich für die Hochfrequenz Anwendungen in aller Regel störenden dielektrischen Verluste in dem 2. Material gezielt ausgenutzt werden können, um eine Kapazität zur Absumpfung hochfrequenter Leistung auszubilden. Dazu sind zumindest eine Signalleitungsstruktur auf dem ersten Trägersubstrat und zumindest eine mit elektrischem Massepotential verbundene Masselage auf einer Seite zumindest eines zweiten Trägersubstrats sowie elektrischen Durchkontaktierungen durch die Trägersubstrate vorgesehen und die Kapazität wird durch zumindest ein zweites Trägersubstrat hin zur Masselage gebildet, indem auf der der Masselage gegenüberliegenden Seite des zweiten Trägersubstrats eine Metallisierungsfläche mit einer der gewünschten Kapazität entsprechenden Größe ausgebildet und die Metallisierungsfläche über eine Durchkontaktierung mit der Signalleitungsstruktur verbunden ist.

In einer bevorzugten Ausgestaltung besteht die Mehrebenenleiterplatte aus zumindest 3 Trägersubstraten, wobei eine erste Massenlage zwischen dem ersten Trägersubstrat und dem zweiten Trägersubstrat vorgesehen ist und an das zweite Trägersubstrat ein drittes Trägersubstrat ebenfalls aus dem zweiten Material angeordnet ist und die Metallisierungsfläche der Kapazität zwischen dem zweiten und dritten Trägersubstrat ausgebildet und auf der gegenüberliegenden Seite des dritten Trägersubstrats eine zweite Masselage angeordnet ist. Die Metallisierungsfläche der Kapazität ist also beidseitig von Trägersubstraten mit gewünschten dielektrischen Verlusten umgeben und kann so die Größe der Metallisierungsfläche optimal ausnutzen und eine Abstrahlung in das 1. Trägersubstrat besser verhindern.

In einer weiteren bevorzugten Ausgestaltung weist die Mehrebenenleiterplatte um die Metallisierungsfläche mehrere verteilt angeordnete Durchkontaktierungen in vorgegebenem Abstand zur Metallisierungsfläche jeweils von der ersten zur zweiten Masselage auf. Diese Durchkontaktierungen ermöglichen auch eine Verhinderung seitlicher Abstrahlung elektromagnetischer Wellen aus dem Bereich der Kapazität in andere Teile der Trägersubstrate aus 2. Material und somit können diese für weitere Teile der Schaltung ohne weiteres verwendet werden.

Die Erfindung wird nun nachfolgend anhand von Ausführungsbeispielen unter Zuhilfenahme der Figuren näher erläutert. Im Folgenden können für funktional gleiche und/oder gleiche Elemente mit den gleichen Bezugsziffern bezeichnet sein.

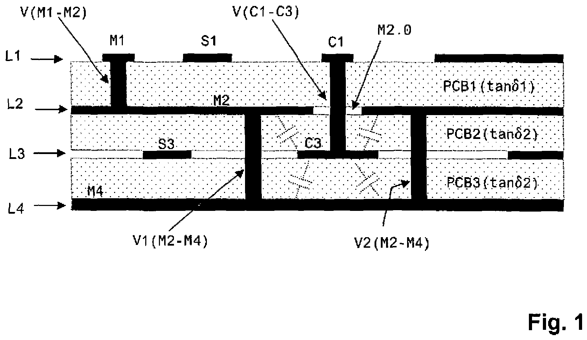

Die Figur 1 zeigt in der besonders bevorzugten Ausgestaltung die Mehrebenenleiterplatte mit 3 Trägersubstraten und damit 4 Metallisierungs-Ebenen, wobei das 1. Trägersubstrat aus einem 1., hochfrequenzgeeigneten Material besteht und das 2. und 3. Trägersubstrat aus einem demgegenüber billigeren Material mit höheren dielektrischen Verlusten besteht. Da es am Markt durchaus eine große Anzahl derartiger geeigneter Trägersubstrate gibt, kann eine Material Auswahl hier immer nur als ein Vorschlag und Ausführungsbeispiel angegeben werden, ohne dass dies den Schutzbereich der Anmeldung beschränkt. Vorzugsweise gilt bei einer für eine Anwendung vorgegebenen Nutzsignalfrequenz, dass der Verlustwinkel tanδ2 des Materials des zweiten beziehungsweise 3. Trägersubstrats mindestens dem Faktor 3 des Verlustwinkel tanδ1 des Materials des ersten Trägersubstrats PCB1 entspricht, also gilt: tanδ2>3*tanδ1.

Die entstehenden dielektrischen und ohmschen Verluste sind jedoch maßgeblich von der jeweiligen Signalfrequenz und dem jeweiligen Verlustwinkel sowie der Ausgestaltung der Leitfähigkeit abhängig, Daher ist es nicht möglich, den Verlustwinkel als Absolutwert sinnvoll anzugeben. Der Fachmann kann jederzeit für die gewählte Anwendung, also beispielsweise 77 GHz für ein Abstandsmessradar, die jeweiligen Materialien geeignet auswählen.

Zudem weist die Mehrebenenleiterplatte eine Signalleitungsstruktur S1,C1 auf dem ersten Trägersubstrat PCB1 und zumindest eine, die bevorzugt 2 mit elektrischem Massepotential verbundene Masselagen M2,M4 auf je einer Seite der zwei zweiten Trägersubstrate PCB2, PCB3 auf.

Auf der den Masselagen M2 und M4 gegenüberliegenden Seite des zweiten bzw. dritten Trägersubstrats PCB2,3, also in der Metallisierungsebene L3 ist eine Metallisierungsfläche C3 mit einer der gewünschten Kapazität bei der Anwendungsfrequenz entsprechender Größe und Form ausgebildet und die Metallisierungsfläche (C3) ist über eine Durchkontaktierung (V(C1-C3)) mit der Signalleitungsstruktur (C1) verbunden.

Von der Metallisierungsfläche (C3) durch das zweite und dritte Trägersubstrat (PCB2,PCB3) hin zu den Masselagen (M2,M4) wird als die Kapazität zur Absumpfung hochfrequenter Leistung auf Bezugspotential ausgebildet, wie skizzenhaft in der Figur bereits veranschaulicht ist. Dabei werden gezielt die schlechteren höheren dielektrischen Verluste des billigeren Trägersubstrats ausgenutzt.

Generell könnte jedoch auf das 3. Trägersubstrat verzichtet und die Metallisierungsfläche in der 2. Metallisierungsebene L2 unmittelbar zwischen dem 1. und 2. Trägersubstrat angeordnet und bereits in der 3. Metallisierungsebene die Bezugs-Masselage angeordnet sein. Jedoch wären bei einer solchen Ausgestaltung die EMV-Abstrahlung in das 1. und 2. Trägersubstrat höher und die Größe der Metallisierungsfläche größer als bei der in der Figur gezeigten bevorzugten Ausgestaltung.

Die Mehrebenenleiterplatte weist in vorgegebenem Abstand zur Metallisierungsfläche (C3) zumindest eine Durchkontaktierung (V(M2-M4)) von der ersten Masselage (M2) zur zweiten Masselage (M4) hin auf. Besonders bevorzugt jedoch sind mehrere um die Metallisierungsfläche räumlich vorzugsweise in etwa gleichmäßig verteilt angeordnete Durchkontaktierungen (V1(M2-M4), V2(M2-M4)) in vorgegebenem Abstand zur Metallisierungsfläche (C3) jeweils von der ersten zur zweiten Masselage M2-M4 hin vorgesehen. Diese bilden quasi einen Faraday'schen Käfig um die Metallisierungsfläche des Kondensators und schützen damit die beiden anliegenden Trägersubstrate gegen seitliche EMV-Verkopplungen, so dass in der 3. Metallisierungsebene weitere Leiterbahnen S3 angeordnet werden können.

Die Größe und Form der Metallisierungsfläche des Kondensators bestimmt dabei die Kapazität und diese zusammen mit dem Induktivitätsbelag der Verbindung zur Metallisierungsfläche C3 eine Resonanzfrequenz die gezielt auf die für die Anwendung benötigte Frequenz abgestimmt werden kann.

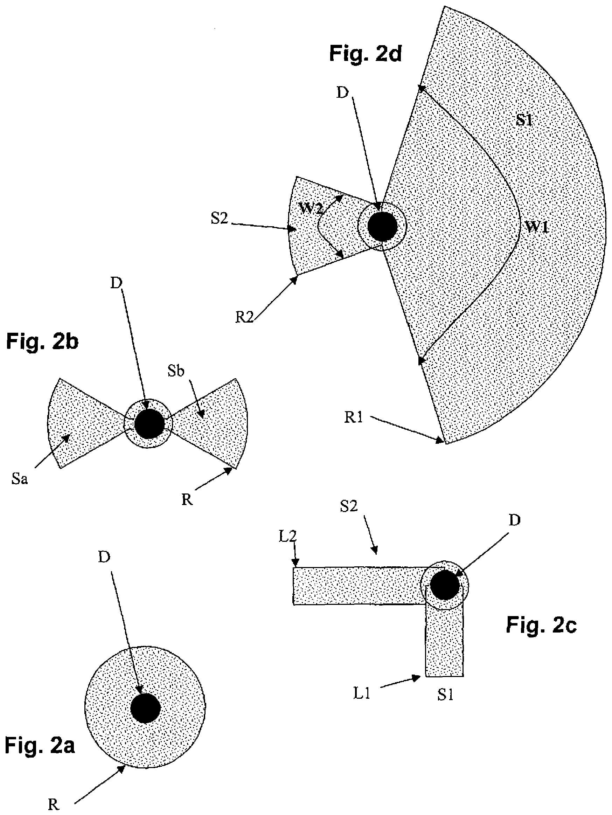

Zudem beeinflusst gerade für die Hochfrequenzanwendungen der Abstand des Aussenrands der Metallisierungsfläche zum Zentrum der Durchkontaktierung ebenfalls die Dämpfungscharakteristik des Systems. Erreicht man nämlich einen Abstand von zumindest annähernd ein durch ein mit einer rationalen Zahl ausdrückbares Verhältnis der Wellenlänge der zu eliminierenden Störfrequenz, so entsteht quasi eine stehende Welle und verstärkt sich die Dämpfung und damit Elimination entscheidend. Natürlich ist diese Wirkung bei exakter Übereinstimmung am größten, kann jedoch bei den praktisch kaum vermeidbaren Abweichungen trotzdem noch eine hinreichend gute Wirkung erreicht werden. Neben der Größe der Metallisierungsfläche und damit deren Kapazität bestimmt also der Abstand des Aussenrands der Metallisierungsfläche zum Zentrum der Durchkontaktierung nochmal die Wirkung. Betrachtet man zunächst Figur 2a, so ist hier die Metallisierungsfläche als Vollkreis mit dem Radius R ausgebildet. Der Radius R bestimmt zugleich die Größe der Fläche.

Wechselt man jedoch zu einem Kreissegment, den sogenannten "radial stubs", oder gar zwei solchen Kreissegmenten, sogenannten "butterfly-stubs", wie in Fig. 2b, so bietet diese Formung die Möglichkeit, einerseits über den Radius den Abstand des Aussenrands der Metallisierungsfläche zum Zentrum der Durchkontaktierung eine Optimierung auf die Wellenlänge der Störfrequenz bzw. Störwelle vorzunehmen, andererseits aber über den Winkel des bzw. der Segmente die Fläche und damit Kapazität unabhängig voneinander zu beeinflussen und somit beide Größen unabhängig auf den jeweiligen Anwendungsfall hin zu optimieren.

Natürlich können mit hinreichender technischer Näherung auch andere eben nicht kreisrunde Formen, bspw. rechteckförmige Segmente verwendet werden, bei denen natürlich im mathematischen Sinne der Abstand des Aussenrands der Metallisierungsfläche zum Zentrum der Durchkontaktierung gerade nicht konstant der Länge der Seitenfläche des Rechtecks entspricht, zumindest bei hinreichend schmaler Breite B dieser Rechteckflächen, also einer Breite « deren Länge dies vernachlässigbar ist. Solche Rechteckflächen, wie in Fig. 2c gezeigt, lassen sich aber evt. deutlich leichter exakt strukturieren als Kreissegmente und bieten ebenfalls die Möglichkeit, den Abstand des Aussenrands der Metallisierungsfläche zum Zentrum der Durchkontaktierung einerseits auf die Wellenlänge der Störwelle hin zu optimieren, andererseits unabhängig davon die Kapazität durch Anpassung der Breite des Rechtecks zu bestimmen. Natürlich gingen als eine Zwischenform auch beispielsweise trapezförmige Segmente mit einer schmalen Seite an der Durchkontaktierung und einem Aufweiten der Fläche nach außen zum Aussenrand der Metallisierungsfläche hin.

Die Fig. 2c zeigt jedoch neben der rechteckförmigen Variante der Segmente auch noch eine ganz entscheidende weitere Weiterbildung, die funktional gleichwirkend auch in Fig. 2d dargestellt ist. So besteht die Metallisierungsfläche (C3) jeweils aus zwei Segmenten S1 und S2 mit unterschiedlichem Abstand R1>R2 bzw. L1<L2. Jeder dieser Abstände ist dabei auf eine andere zu eliminierende Störfrequenz hin optimiert, d.h. mit zwei solchen Segmenten können mit einer Metallisierungsstruktur auch gleich zwei unterschiedliche Störfrequenzen eliminiert werden, indem der jeweilige Abstand R1,R2,L1,L2 des Aussenrands dieses Segments zum Zentrum der Durchkontaktierung auf jeweils zumindest annähernd durch ein mit einer rationalen Zahl ausdrückbares Verhältnis der Wellenlänge zu diesen Störfrequenzen f1,f2 gerichtet wird. Nimmt man noch mehr Segmente mit unterschiedlichem Abstand, kann man auch auf noch andere Störfrequenzen reagieren, bspw. weitere Oberwellen abfangen.

Die Größe dieser Segmente, also beispielsweise bei den Kreissegmenten bestimmt durch deren Winkel W1,W2 oder bei Rechtecken deren Breite B1,B2 ist entsprechen der gewünschten Kapazität bei dieser Störfrequenz ausgerichtet.

Natürlich ist die Fläche um die Durchkontaktierung nur beschränkt und gibt es bei der Menge unterschiedlicher Segmente mit unterschiedlichem Abstand dann schnell Grenzen bei der dabei noch verfügbaren variablen Breite bzw. Winkel, aber kann eben durchaus über entsprechende Formung der Flächen hier eine Optimierung erfolgen.

Natürlich können auch für eine bestimmte Störfrequenz trotzdem mehrere Segmente mit gleichem Abstand, also bspw. wieder eine Butterfly-Form wie in Figur 2b vorgesehen sein, d.h. eine Form mit vier oder noch mehr Segmenten entstehen.

Zudem kann über die Wahl des konkreten Materials und der Eigenschaften der Metallisierungsfläche die Kapazität und vor allem auch zusätzlich deren ohmsche Verluste zwecks des Ableitens oder besser Versumpfens von Störenergie, also der Umwandlung dieser Energie in Wärme erreicht werden. So kann durch gezielte Wahl besonders dünner Metallisierungsflächen bspw. bei Kupfer durchaus auch unter 15*µ*m der ohmsche Verlust erhöht werden. Während für normale Schaltungsanwendungen in der Regel immer eine besondere hohe Güte und Glattheit der Oberfläche der Metallisierung gewünscht wird, kann für die gezielte Erzeugung dieser Verluste auch die Oberfläche der Metallisierung eben gezielt rau ausgestaltet und so die Verlustrate weiter erhöht werden.

Diese Maßnahmen können durch entsprechende Simulationsprogramme heutzutage gut am Rechner auf den jeweiligen Anwendungsfall hin optimiert werden, lassen sich hier aber nur die grundsätzlichen Einflussmöglichkeiten aufzeigen und ist die Erfindung nicht auf eine einzelne Form oder Maßnahmen beschränkt.

Eine solche Mehrebenenleiterplatte eignet sich für Hochfrequenz-Anwendungen, beispielsweise einem Gleichspannungszuführungsfilter eines Verstärkers in Hochfrequenz, vorzugsweise größer 1 GHz-Bereich, insbesondere auch für Abstandsmessradare in Kraftfahrzeugen.

Vorzugsweise findet solch eine beispielhafte Ausführung Anwendung bei Frequenzen oberhalb von 1 GHz.

## Patentansprüche

1. Mehrebenenleiterplatte für Hochfrequenz-Anwendungen
mit zumindest einem ersten Trägersubstrat (PCB1) aus hochfrequenzgeeignetem ersten Material und
zumindest einem zweiten Trägersubstrat (PCB2,3)
sowie zumindest einer Signalleitungsstruktur (S1,C1) auf dem ersten Trägersubstrat (PCB1) und zumindest einer mit elektrischem Massepotential verbundener Masselage (M2,4) auf einer Seite des zumindest einen zweiten Trägersubstrats (PCB2,3)
sowie elektrischen Durchkontaktierungen (V) durch die Trägersubstrate (PCB1,2,3),
wobei durch das zumindest eine zweite Trägersubstrat (PCB2,3) zur Masselage (M2,4) hin eine Kapazität zur Ableitung hochfrequenter Leistung auf Massepotential ausgebildet ist,
**dadurch gekennzeichnet, dass**
das zweite Trägersubtrat (PCB 2,3) aus einem zweiten Material mit gegenüber dem ersten Material höheren dielektrischen Verlusten ausgebildet ist und
die Kapazität durch das zumindest eine zweite Trägersubstrat (PCB2,3) zur Masselage (M2,M4) hin dadurch ausgebildet ist,
indem auf der der Masselage (M2,4) gegenüberliegenden Seite des zumindest einen zweiten Trägersubstrats (PCB2,4) eine Metallisierungsfläche (C3) mit einer der gewünschten Kapazität entsprechenden Größe ausgebildet und die Metallisierungsfläche (C3) über eine Durchkontaktierung (V(C1-C3)) mit der Signalleitungsstruktur (C1) verbunden ist.

2. Mehrebenenleiterplatte nach Anspruch 1, **dadurch gekennzeichnet, dass**
eine erste Massenlage zwischen dem ersten Trägersubstrat (PCB1) und dem zweiten Trägersubstrat (PCB2) vorgesehen ist und an das zweite Trägersubstrat (PCB2) ein dritter Trägersubstrat (PCB3) ebenfalls aus dem zweiten Material angeordnet ist,
wobei die Metallisierungsfläche (C3) der Kapazität zwischen dem zweiten (PCB2) und dritten (PCB3) Trägersubstrat ausgebildet und auf der gegenüberliegenden Seite des dritten Trägersubstrats (PCB3) eine zweite Masselage (M4) angeordnet ist.

3. Mehrebenenleiterplatte nach Anspruch 2, **dadurch gekennzeichnet, dass** in vorgegebenem Abstand zur Metallisierungsfläche (C3) zumindest eine Durchkontaktierung (V(M2-M4)) von der ersten Masselage (M2) zur zweiten Masselage (M4) hin vorgesehen ist.

4. Mehrebenenleiterplatte nach Anspruch 3, **dadurch gekennzeichnet, dass** zumindest mehr als eine um die Metallisierungsfläche (C3) verteilt angeordnete Durchkontaktierungen (V1(M2-M4), V2(M2-M4)) in vorgegebenem Abstand zur Metallisierungsfläche (C3) jeweils von der ersten zur zweiten Masselage hin vorgesehen sind.

5. Mehrebenenleiterplatte nach einem der vorangehenden Ansprüche, **dadurch gekennzeichnet, dass** bei einer für eine Anwendung vorgegebenen Nutzsignalfrequenz der Verlustwinkel (tanδ2) des Materials des zweiten Trägersubstrats (PCB2,3) mindestens dem Faktor 3 des Verlustwinkels (tanδ1) des Materials des ersten Trägersubstrats (PCB1) entspricht (tanδ2>3*tanδ1).

6. Mehrebenenleiterplatte nach einem der vorangehenden Ansprüche, **dadurch gekennzeichnet, dass** die Kapazität zusammen mit dem Induktivitätsbelag der Verbindung zur Metallisierungsfläche (C3) auf eine für die Anwendung gezielt benötigte Frequenz zur Absumpfung der Hochfrequenzleistung abgestimmt ist.

7. Mehrebenenleiterplatte nach einem der vorangehenden Ansprüche, **dadurch gekennzeichnet, dass** der Abstand (R,R1,R2,L1,L2) des Aussenrands der Metallisierungsfläche (C3) zum Zentrum der Durchkontaktierung so bestimmt wird, dass zumindest annähernd ein durch ein mit einer rationalen Zahl ausdrückbares Verhältnis der Wellenlänge zur eliminierenden Störfrequenz entsteht und zudem die Größe (W) der Metallisierungsfläche (C3) derart bestimmt ist, dass die gewünschte Kapazität zumindest annähernd erreicht ist.

8. Mehrebenenleiterplatte nach einem der vorangehenden Ansprüche, **dadurch gekennzeichnet, dass** die Metallisierungsfläche (C3) aus zumindest einem nicht kreisförmigen, vorzugsweise teilkreissegmentförmigen, trapezförmigen oder rechteckigen Segment (S) besteht, wobei der Abstand (R,L) des Aussenrandes des Segments zum Zentrum der Durchkontaktierung zumindest annähernd durch ein mit einer rationalen Zahl ausdrückbares Verhältnis der Wellenlänge zur eliminierenden Störfrequenz entsteht und andererseits die Flächengröße und damit die Kapazität der Metallisierungsfläche (C3) entsprechend zumindest annähernd der gewünschten Kapazität bestimmt ist.

9. Mehrebenenleiterplatte nach einem der vorangehenden Ansprüche, **dadurch gekennzeichnet, dass** die Metallisierungsfläche (C3) aus zumindest zwei Segmenten (S1,S2) besteht, wobei zumindest zwei dieser Segmente einen unterschiedlichen Abstand (R1,R2,L1,L2) des Aussenrands zum Zentrum der Durchkontaktierung aufweisen und der jeweilige Abstand (R1,R2,L1,L2) des Aussenrands dieses Segments zum Zentrum der Durchkontaktierung auf jeweils zumindest annähernd durch ein mit einer rationalen Zahl ausdrückbares Verhältnis der Wellenlänge der zu eliminierenden Störfrequenzen (f1,f2) und die Größe (W1,W2) dieses Segments der Metallisierungsfläche (C3) entsprechend der gewünschten Kapazität bei diesen Störfrequenzen entspricht.

10. Verwendung einer Mehrebenenleiterplatte nach einem der vorangehenden Ansprüche als Gleichspannungszuführungsfilters eines Verstärkers in Hochfrequenz, vorzugsweise größer 1 GHz-Bereich, insbesondere für Abstandsmessradar in Kraftfahrzeugen

## Claims

1. Multi-level circuit board for high-frequency applications
with at least one first carrier substrate (PCB1) made of a first material suitable for high frequencies, and
at least one second carrier substrate (PCB2,3)
and at least one signal transmission structure (S1,C1) on a first carrier substrate (PCB1) and at least one ground plane (M2,4) connected to electrical ground potential on one side of the at least one second carrier substrate (PCB2,3)
and electrical through-connections (V) through the carrier substrate (PCB1,2,3),
wherein through the at least one second carrier substrate (PCB2,3) towards the ground plane (M2,4), a capacity for deflecting high-frequency power to ground potential is created,
**characterized in that**
the second carrier substrate (PCB 2,3) is formed from a second material with higher dielectrical losses in relation to the first material, and
the capacity through the at least one second carrier substrate (PCB2,3) towards the ground plane (M2,M4) is created by means of the fact that
on the side of the at least one second carrier substrate (PCB2,4) located opposite the ground plane (M2,4), a metallization surface (C3) is formed with a size that corresponds to the desired capacity, and the metallization surface (C3) is connected to the signal transmission structure (C1) via a through-contact (V(C1-C3)).

2. The multi-level circuit board according to claim 1, **characterized in that**
one first ground plane is provided between the first carrier substrate (PCB1) and the second carrier substrate (PCB2), and on the second carrier substrate (PCB2), a third carrier substrate (PCB3), is also arranged from the second material,
wherein the metallization surface (C3) of the capacity is formed between the second (PCB2) and third (PCB3) carrier substrate, and
on the opposite side of the third carrier substrate (PCB3), a second ground plane (M4) is arranged.

3. The multi-level circuit board according to claim 2, **characterized in that** at the specified distance from the metallization surface (C3), at least one through-contact (V(M2-M4)) from the first ground plane (M2) towards the second ground plane (M4) is provided.

4. The multi-level circuit board according to claim 3, **characterized in that** at least more than one through-contacts (V1(M2-M4), V2(M2-M4)) are arranged distributed around the metallization surface (C3) at the specified distance from the metallization surface (C3), in each case provided from the first to the second ground plane.

5. The multi-level circuit board according to any one of the preceding claims, **characterized in that** with a specified useful signal frequency the loss angle (tan δ2) of the material of the second carrier substrate (PCB2,3) corresponds at least to factor 3 of the loss angle (tanδ1) of the material of the first carrier substrate (PCB1) (tan δ2> tan δ1).

6. The multi-level circuit board according to any one of the preceding claims, **characterized in that** the capacity, together with the inductance per length unit of the connection to the metallization surface (C3) is coordinated with a targeted required frequency for the application for the dissipation of the high-frequency capacity.

7. The multi-level circuit board according to any one of the preceding claims, **characterized in that** the distance (R, R1 ,R2,L1, L2) of the outer edge of the metallization surface (C3) from the center of the through-contact is determined in such a manner that, at least approximately, a ratio is created by a ratio between the wavelength and the eliminating interference frequency which can be expressed by a rational number, and additionally, the size (W) of the metallization surface (C3) is determined in such a manner that the required capacity is at least approximately achieved.

8. The multi-level circuit board according to any one of the preceding claims, **characterized in that** the metallization surface (C3) from at least one non-circular, preferably partially circle segment-shaped, trapezoid or rectangular segment (8) exists, wherein the distance (R,L) between the outer edge of the segment and the center of the through-contact is created at least approximately by a ratio between the wavelength and the eliminating interference frequency which can be expressed by a rational number, and on the other hand, the surface size and thus the capacity of the metallization surface (C3) is at least approximately determined according to the required capacity.

9. The multi-level circuit board according to any one of the preceding claims, **characterized in that** the metallization surface (C3) consists of at least two segments (S1, S2), wherein at least two of these segments have a different distance (R1,R2,L1,L2) between the outer edge and the center of the through-contact, and the respective distance (R1,R2,L1,L2) between the outer edge of this segment and the center of the through-contact corresponds in each case at least approximately to a ratio, which can be expressed by a rational number, between the wavelength of the interference frequencies (f1, f2) to be eliminated and the size (W1, W2) of this segment of the metallization surface (C3) according to the desired capacity with these interfering frequencies.

10. The use of a multi-level circuit board according to any one of the preceding claims as a DC voltage feed filter of an amplifier in high frequency, preferably greater than the 1 GHz range, in particular for distance measurement radars in motor vehicles.

## Revendications

1. Circuit imprimé multicouches pour applications haute fréquence
avec au moins un premier substrat support (PCB1) en un premier matériau adapté à la haute fréquence et
au moins un deuxième substrat support (PCB2,3)
ainsi qu'au moins une structure de transmission de signal (S1, C1) sur le premier substrat support (PCB1) et au moins un plan de masse connecté à un potentiel de masse électrique (M2,4) sur un côté de l'au moins un deuxième substrat support (PCB2, 3)
ainsi que des vias électriques (V) à travers les substrats supports (PCB1,2,3),
une capacité pour la dérivation de puissance à haute fréquence sur le potentiel de masse étant formée à travers l'au moins un deuxième substrat support (PCB2,3) vers le plan de masse (M2,4),
**caractérisé en ce que**
le deuxième substrat support (PCB2,3) est formé en un deuxième matériau avec des pertes diélectriques plus élevées comparativement au premier matériau et
la capacité à travers l'au moins un deuxième substrat support (PCB2,3) vers le plan de masse (M2,M4) étant formée par le fait qu'
une surface de métallisation (C3) avec une taille correspondant à la capacité souhaitée est formée sur le côté de l'au moins un deuxième substrat support (PCB2,4) opposé au plan de masse (M2,4) et que la surface de métallisation (C3) est reliée à la structure de transmission de signal (C1) par un via (V(C1-C3).

2. Circuit imprimé multicouches selon la revendication 1, **caractérisé en ce qu'**
un premier plan de masse est prévu entre le premier substrat support (PCB1) et le deuxième substrat support (PCB2) et un troisième substrat support (PCB3), également en deuxième matériau, est disposé sur le deuxième substrat support (PCB2).
la surface de métallisation (C3) de la capacité étant formée entre le deuxième (PCB2) et le troisième (PCB3) substrats supports et
un deuxième plan de masse étant disposé sur le côté opposé du troisième substrat support (PCB3).

3. Circuit imprimé multicouches selon la revendication 2, **caractérisé en ce qu'**au moins un via (V(M2-M4)) est prévu du premier plan de masse (M2) au deuxième plan de masse (M4), à une distance spécifiée de la surface de métallisation (C3).

4. Circuit imprimé multicouches selon la revendication 3, **caractérisé en ce qu'**au moins plus d'un via (V1(M2-M4), V2(M2-M4)), répartis autour de la surface de métallisation (C3), sont prévus respectivement du premier plan de masse au deuxième plan de masse (V2), à une distance spécifiée de la surface de métallisation (C3).

5. Circuit imprimé multicouches selon l'une des revendications précédentes,**caractérisé en ce que**, à une fréquence de signal utile spécifiée pour une application, l'angle de perte (tanδ2) du matériau du deuxième substrat support (PCB2,3) correspond au moins au facteur 3 de l'angle de perte (tanδ1) du matériau du premier substrat support (PCB1) (tanδ2>3*tanδ1).

6. Circuit imprimé multicouches selon l'une des revendications précédentes, **caractérisé en ce que** la capacité, conjointement à la constante d'inductance de la connexion avec la surface de métallisation (C3), est accordée sur une fréquence spécifiquement nécessaire à l'application en vue de la dissipation de la puissance à haute fréquence.

7. Circuit imprimé multicouches selon l'une des revendications précédentes, **caractérisé en ce que** la distance (R, R1, R2, L1, L2) du bord extérieur de la surface de métallisation (C3) au centre du via est déterminée de telle sorte qu'un rapport se constitue au moins de façon approximative par un rapport entre la longueur d'onde et la fréquence parasite devant être éliminée exprimable par un nombre rationnel et, en outre, **en ce que** la taille (W) de la surface de métallisation (C3) est déterminée de telle sorte que la capacité souhaitée est atteinte au moins de façon approximative.

8. Circuit imprimé multicouches selon l'une des revendications précédentes, **caractérisé en ce que** la surface de métallisation (C3) se compose d'au moins un segment non circulaire, de préférence en forme de segment partiellement circulaire, en forme de trapèze ou rectangulaire (S), la distance (R, L) du bord extérieur du segment au centre du via se constituant au moins de façon approximative par un rapport entre la longueur d'onde et la fréquence parasite devant être éliminée exprimable par un nombre rationnel et, d'autre part, la taille de la surface et par suite la capacité de la surface de métallisation (C3) étant déterminée au moins de façon approximative corrélativement à la capacité souhaitée.

9. Circuit imprimé multicouches selon l'une des revendications précédentes, **caractérisé en ce que** la surface de métallisation (C3) se compose d'au moins deux segments (S1, S2), au moins deux de ces segments présentant une distance différente (R1,R2,L1,L2) du bord extérieur au centre du via, et la distance respective (R1,R2,L1,L2) entre le bord extérieur de ce segment et le centre du via correspondant respectivement au moins de façon approximative à un rapport, exprimable par un nombre rationnel, entre la longueur d'onde des fréquences parasites (f1, f2) devant être éliminées et la taille (W1,W2) de ce segment de la surface de métallisation (C3) corrélativement à la capacité souhaitée à ces fréquences parasites.

10. Utilisation d'un circuit imprimé multicouches selon l'une des revendications précédentes comme filtre d'alimentation en tension continue d'un amplificateur à haute fréquence, de préférence supérieure à la zone d'1 GHz, en particulier pour des radars de mesure de distance sur des véhicules.
